# EUROPEAN PATENT SPECIFICATION

(11) **EP 0 633 661 B1**
(45) Date of publication and mention of the grant of the patent: **13.10.1999**
(21) Application number: 94830332.6
(22) Date of filing: 04.07.1994
(51) Int. Cl.: H03J 1/00, H04B 1/20

(54) **Remote control systems**
Fernsteuerungssysteme
Systèmes de télécommande

(30) Priority: 05.07.1993 IT RM930436
(43) Date of publication of application: 11.01.1995
(73) Proprietor: TEXAS INSTRUMENTS INCORPORATED, Dallas, Texas 75243 (US); TEXAS INSTRUMENTS ITALIA S.p.A., 02015 Cittaducale (RI) (IT)
(72) Inventor: Savarese, Giuseppe, I-80122 Napoli (IT)
(74) Representative: Taliercio, Antonio

(56) References cited:
- WO-A-89/03085
- DE-A- 3 821 355
- DE-A- 4 011 067
- PATENT ABSTRACTS OF JAPAN vol. 17, no. 323 (P-1559) 18 June 1993 & JP-A-05 035 387 (KYOCERA CORP) 12 February 1993
- PATENT ABSTRACTS OF JAPAN vol. 14, no. 433 (E-979) 17 September 1990 & JP-A-02 168 794 (HITACHI COMMUN SYST INC) 28 June 1990
- PATENT ABSTRACTS OF JAPAN vol. 14, no. 391 (E-968) 23 August 1990 & JP-A-02 145 095 (TOSHIBA CORP) 4 June 1990
- PATENT ABSTRACTS OF JAPAN vol. 12, no. 385 (E-668) 14 October 1988 & JP-A-63 129 722 (FUJITSU GENERAL LTD) 2 June 1988

## Description

This invention relates to remote control systems for use with, for example, television sets, videos, stereos and any other equipment where remote control can be used.

Many pieces of electrical equipment can be controlled by remote control devices. These devices typically include a key pad by which data can be entered by the user. The data is then interpreted by appropriate electronic circuitry and an IR signal is transmitted to the equipment to enable the control of the equipment.

With conventional remote controls, each different type of TV or video usually needs a completely different remote control, since there are different functions and facilities for different televisions or videos. Obviously, this means the manufacturer will have to make many different remote controllers to cope with equipment's requirements derived from customer's needs. The invention provides a means to greatly simplify the development, production and maintenance costs of remote controls, by providing only one mechanical model customisable via software.

In addition, use of the remote controller may be very difficult for certain functions. For example, when one is programming a video, via the remote controller, to come on at a certain time and on a certain day for a specified period of time, it is necessary to press many buttons in a given sequence. It is very easy to make a mistake either with or without realising it. This can mean either having to reprogram the video or missing the program you had wanted to watch through errant programming.

WO-A-8903085 discloses a remote control device for remotely controlling one or more pieces of electrical equipment comprising a touch sensitive screen for displaying symbols indicative of control variables of the or each respective piece of equipment and for receiving inputs from a user, in use, a microcontroller for generating the respective set of symbols and interpreting said input, transmitter means for transmitting a control signal to the equipment in response to instructions from the microcontroller, and a memory for storing one or more of said sets of symbols accessible, in use, by the microcontroller to display the required set of symbols on said screen.

DE-A-4011067 discloses a transmitter for a remote control comprising a switch device to provide a set of commands including a plurality of operation switches and a control device to generate a remote control signal.

JP-A-05035387 discloses a device comprising a touch panel to recognize hand-written character.

One object of the present invention is to provide a remote controller which overcomes at least some of the disadvantages of the conventional remote controllers.

According to one aspect of the present invention as defined the appended claims, there is provided a remote control device for remotely controlling one or more pieces of electrical equipment comprising a touch sensitive screen for displaying one or more sets of icons indicative of control variables of the or each respective piece of equipment and for receiving inputs from a user, in use; a microcontroller for generating the respective set of icons and interpreting said inputs; transmitter means for transmitting a control signal to the equipment in response to instructions from the microcontroller; and a memory for storing one or more of said sets of icons accessible, in use, by the microcontroller to display the required set of icons on said screen.

This has the advantages that is both easy to use and easily adapted to control different equipment.

Reference will now be made by way of example, to the accompanying drawings, in which:
Figure 1 is a schematic drawing of a system in which a remote control according to the invention may be used;
Figure 2 is a block diagram of the remote controller of Figure 1;
Figure 3 is a schematic drawing showing a first possible screen on the Figure 2 controller; and
Figure 4 is a schematic drawing showing a possible programming screen on the Figure 2 controller.

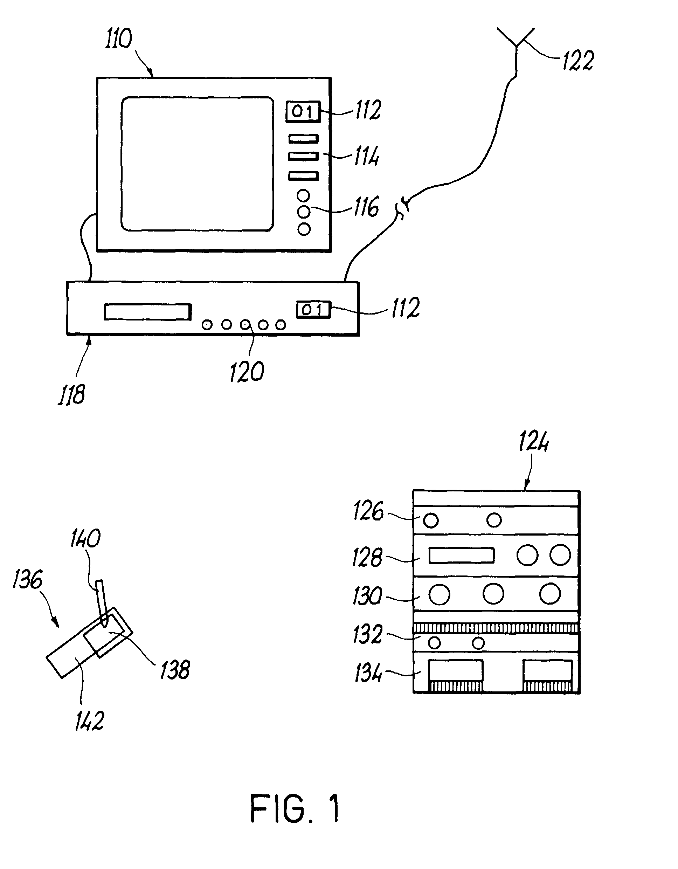

Referring to Figure 1, a home entertainment system is illustrated. The system includes a television set 110, a video recorder and player 118 and a stereo system 124. In use, a user can control the three pieces of electrical equipment by use of a remote controller 136. The television set includes a channel indicator 112, slider controls 114, control buttons 116, all of which can be controlled using the remote controller 136. This will described in more detail subsequently.

The video player-recorder includes control buttons 120 and video channel indicators 112. The television may be connected by a co-axial cable to the video and the video is connected via co-axial cable to an external aerial 122.

The stereo system may typically include a record player 126, a CD player 128, an amplifier 130, a radio tuner 132 and a tape deck 134. Each of these components of the stereo may be controlled by the remote controller 136.

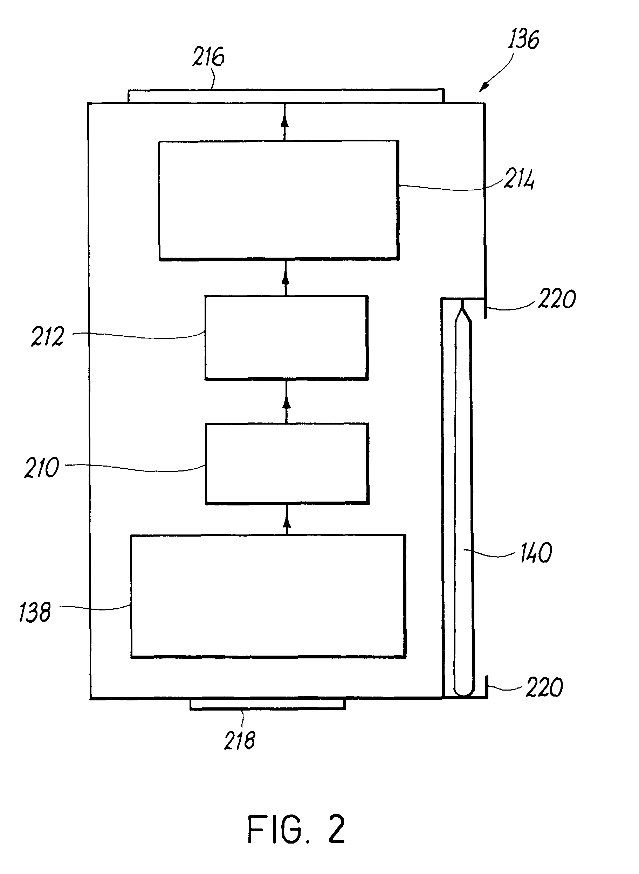

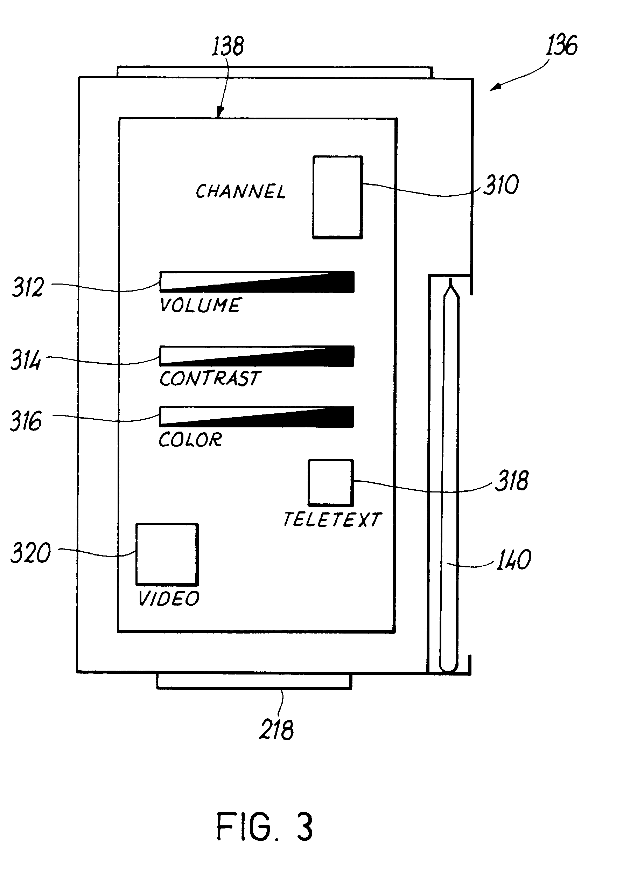

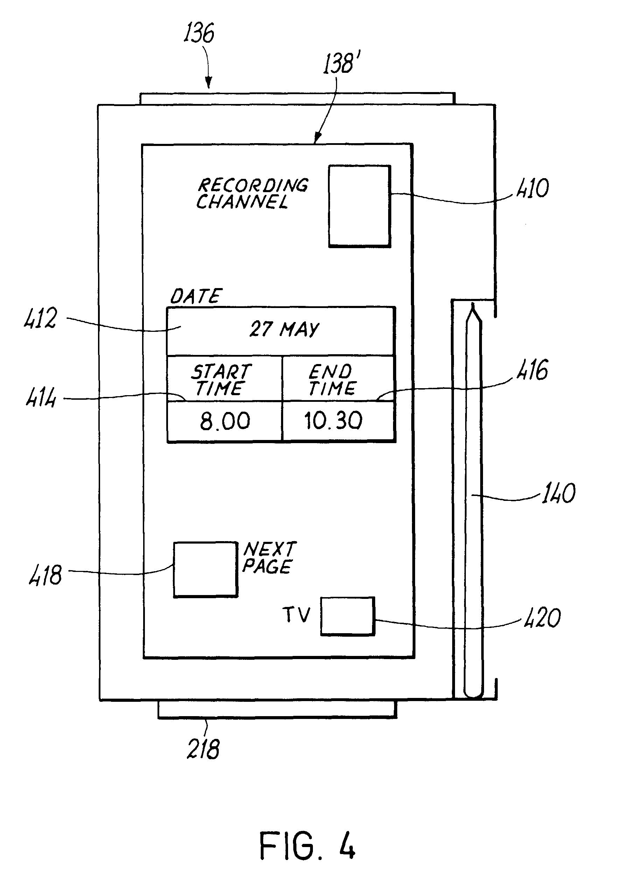

The remote controller of the present invention is adapted for use with all of the electrical devices described above. The controller 136 includes on its top surface a touch sensitive screen 138. For example, an LCD graphic digitiser. In Figures 1 and 2, the touch sensitive screen is shown covering only part of the remote controller, however, it is anticipated that the screen will form most of the top surface of the controller as it is shown in Figure 3 and 4. The touch sensitive screen is capable of receiving input either via fingers touching the screen or by means of a pen or stylus 140. When not in use, the pen may be held in the pen space 142 providing a compact remote controller similar in shape and size to conventional remote controllers.

The remote controller may be used to control devices other than those described and shown in Figure 1, for example, washing machines, door entry systems and the like.

Referring to Figure 2, the remote controller is shown in greater detail. The pressure sensitive screen includes pressure sensitive membrane placed on top of an LCD digitising tablet. This tablet is capable of detecting the pressure of a finger on a given area or the writing path of the pen on the screen.

A microcontroller 210 is connected to the pressure sensitive screen to receive the inputs generated thereon. It is also capable of driving the LCD tablet with images of a specific keyboard for a given mode of operation of the remote controller. This will be described in more detail with reference to Figures 3 and 4 later. The microcontroller is also capable of interpreting the input commands whether entered as hand written characters by the pen or by fingers touching the screen. In the case of interpreting handwritten characters, the microcontroller includes character recognition apparatus (not shown), for example, as disclosed in European Patent Application 92830656.2 or Italian Patent Application RM93A000179. A further function of the microcontroller is to send control signals to activate an infra-red driver 214 so that signals can be sent via IR transmitter 216 to the equipment being controlled. The software required by the microcontroller 210 may be stored in an EPROM 212 internally in the device. Alternatively, a memory card 218 may be inserted into the device and connectable with the microcontroller to provide different software for different control requirements.

Both the microcontroller and the memory may be in the form of a so called "Smart Card" which is insertable into the remote controller 136. A manufacturer may produce only one form of remote controller 136 and provide the different screens as shown, for example, in Figures 3 and 4 via the memory 210 or memory card 218. This is both easier for the manufacturer and more economical for both the manufacturer and the customer.

Referring to Figures 3 and 4, two possible screens 138 and 138' are shown. The screens in these examples are intended to be used with the pen as the input means rather than using the screen as a touch pad. It will be appreciated that if this screen is used as a finger sensitive screen, the layout and controls may be differently represented. This change in screen may be facilitated by using another memory card 218 or by accessing a different program stored in EPROM 210.

Referring to Figure 3, the screen 138 shows a representation which may be used to control a television set. The user enters the channel required into channel indicator box 310, using pen 140. Character recognition apparatus is used to identify the written symbol and generate the required IR driving signal to the IR transmitter for transmission to the television. The user may also control the volume 312, contrast 314 and colour 316 by moving the pen over the relevant region. The required volume, contrast and colour may thus be achieved.

If the television has a teletext facility, a teletext selector 318 will appear on the screen. By touching the pen in the teletext selector box, a new screen will be generated in which teletext information can be input by the user

If the user has a video link with the television, the video screen may be accessed by touching the video selector 320.

It will be appreciated that other equipment selectors may also be included depending on user requirements. The given remote controller 136 may store a number of pages, each page containing the information for a given screen, each screen being usable for a different piece of end equipment. The user may move through the pages selecting the end equipment which he wishes to control.

In a system where no pen input or mixed input (pen and fingers) is envisaged, each channel number may be represented by a separate channel selector box which is activated by pressure of the finger at the relevant area of the screen. The icon representation on the remote controller for any given television set may have volume, contrast, colour and channel selectors represented in different manners, for example, dials, slider bars or just buttons. The choice is user and manufacturer dependent.

Referring to Figure 4, the screen 138' shows a representation for use in controlling a video recorder. The user enters the channel to be recorded in box 410, the date in box 412 and the start and stop times in boxes 414 and 416 respectively. In the illustrated embodiment, the inputs are made with the pen for 140 and the characters are recognised by the microcontroller so that the information can be transmitted to the video recorder and stored therein. It will be appreciated that other representations may be used to enable programming of the video recorder to take place. For example, a calendar may appear and the user may press the relevant day, a clock may appear for the user to indicate the start and stop times.

It is clearly apparent that when one has made a mistake entering record data, the mistakes can be rectified merely by re-writing the relevant part of the information. If the user wishes to record several television programs, the next page selector may be used to bring up the next video record data. The television selector may be used to return to the television controller mode of operation.

Different icons may be used for selecting different end equipment to be controlled. Each icon bringing up a new screen on the LCD tablet and enabling the user to control the equipment in question. Multiple use buttons are no longer required to facilitate complicated options within a remote controller. Once all the functions on a given screen have been allocated and there are still further functions to be allocated, a new page may be referred to implement these further requirements.

It will be appreciated that any appropriate form of character recognition may be used within this system, not only that described earlier.

In addition to entertainment equipment, all white goods may potentially be controllable with the remote controller as may home security systems, garage doors, etc. A different memory card may be required for each application and a different frequency may be generated by the IR driver and transmitter for each given application.

Typically, the unit will be battery powered by a battery stored within the controller.

## Claims

1. A remote control device (136) for remotely controlling one or more pieces of electrical equipment comprising a touch sensitive screen (138) for displaying one or more sets of icons indicative of control variables of the or each respective piece of equipment and for receiving inputs from a user, in use; a microcontroller (210) for generating the respective set of icons and interpreting said inputs; transmitter means (216) for transmitting a control signal to the equipment in response to instructions from the microcontroller; (210); and a memory (212) for storing one or more of said sets of icons accessible, in use, by the microcontroller to display the required set of icons on said screen, characterized in that the inputs from the user are in the form script written characters entered on the screen (138) with a stylus (140) and the device further comprises character recognition means (210) for recognising the user inputs.

2. A remote control device according to claim 1, characterized in that inputs are made by touching icons appearing on the screen.

3. A remote control device according to claim 1 wherein the memory and the microcontroller form a smart card insertable into the remote controller, in use.

4. A remote control device according to claim 1, wherein the memory comprises a memory card insertable into the remote controller, in use.

5. A remote control device according to any preceding claims, wherein the memory comprises an EPROM.

6. A remote control device according to any preceding claims, wherein the transmitter means comprise an IR transmitter whose signal is decodable, in use, by the equipment to effect the control input by the user.

7. A remote control device according to any preceding claims, wherein the microcontroller selects the required set of icons in response to user input as to the equipment that is to be controlled and is switchable from one set of icons to the next in response to further user input.

8. A remote control device according to any preceding claims for controlling a television set.

9. A remote control device according to any preceding claim for controlling a video recorder/player.

10. A remote control device according to any preceding claims for controlling some or all household electrical equipment.

## Patentansprüche

1. Fernsteuerungsvorrichtung (136) zur Femsteuerung eines oder mehrer Teile eines elektrischen Anordnung, mit einem berürunggempfindlichen Schirm (138) zur Sichtbarmachung einer oder mehreren Reihen von ikonografischen Anzeigen, die Steuerveränderliche des oder eines jeden Teiles der Anordnung anzeigen und Eingaben vom Benutzer während des Gebrauchs erhalten; einer Mikrosteuerung (210) zur Erzeugung der entsprechenden Reihe von ikonografischen Anzeigen und zur Auslegung der vorgenanntn Eingaben; mit Sendemitteln (216) zum Absenden eines Steuersignals zur Anordnung in Beantwortung auf Anweisungen aus der Mikrosteuerung (210); und mit einem Speicher (212) zum Speichern einer oder mehrerer der vorgenannten Reihen von ikonografischen Anzeigen, die während des Gebrauches an der Mikrosteuerung zur Schtbarmachung der gewünschten Reihe von Anzeigen auf dem vorgenannten Schrim zugänglich sind, dadurch gekennzeichnet, dass die Eingaben des Benutzers in der Form von mit einem Stift (140) auf dem Schim (138) aufgebrachten Schriftzeichen sind und die Vorrichtung ausserdem Erkennungsmittel (210) zur Erkennung der Eingaben des Benutzers aufweist.

2. Fernsteuerungsvorrichtung nach Anspruch 1, dadurch gekennzeichnet, dass die Eingaben durch Berührung der am Schirm vorgesehenen ikonographischen Anzeigen eingeführt werden.

3. Fernsteuerungsvorrichtung nach Anspruch 1, worin der Speicher und die Mikrosteuerung eine während des Gebrauchs in die Fernsteuerung einführbare Steuerkarte bilden.

4. Fernsteuerungsvorrichtung nach Anspruch 1, dadurch gekennzeichnet, dass der Speiser eine in die Fernsteuerung einführbare Speisekarte enthält.

5. Fernsteuerungsvorrichtung nach einem der vorhergehenden Ansprüche, worin die Spesekarte einen EPROM enthält.

6. Fernsteuerungsvorrichtung nach einem der vorhergehenden Ansprüche, worin die Sendemittel eine IR-Sender enthalten, dessen Signal während des Gebrauchs durch die vorgenannte Anordnung, zur Durchführung einer Steuereingabe seitens des Benutzers entschlüsselbar ist.

7. Fernsteuerungsvorrichtung nach einem der vorhergehenden Ansprüche, worin die Mikrosteuerung die gewünschte Reihe von ikonographischen Anzeigen in Beantwortung auf die Eingabe des Benutzers, die die zu steuernde Anordnung anbetrifft, auswählt und von einer Reihe von ikonographischen Anzeigen auf die nächste in Beantwortung einer anderen Eingabe des Benutzers umschaltet.

8. Fernsteuerungsvorrichtung nach einem der vorhergehenden Ansprüche, zur Steuerung einer Televisionanordnung.

9. Fernsteuerungsvorrichtung nach einem der vorhergehenden Ansprüche, zur Steuerung eines Video-Aufnahme und - Wiedergabegeräts.

10. Fernsteuerungsvorrichtung nach einem der vorhergehenden Ansprüche, zur Steuerung einiger oder aller Hauswitschaftsgeräte.

## Revendications

1. Dispositif de télécommande (136) pour télécommander un ou plusieurs éléments d'un équipement électrique, comprenant un écran (138) sensible à touches pour visualizer un ou plusieures séries des indications iconique, qui indiquent des variables de contrôle d'élément ou de chacun élément respectif d'équipment et pour recevoir des entrées d'un utilisateur pendant l'usage; un microcontrôleur (210) pour engendrer la série respecive d'indications iconque et pour interpréter lesdites étrées; moyens de transmission (216) pour trasmettre un signal de contrôle à l'équipement en réponse aux instructions du microcontrôleur (210) et un mémoire (212) pour mémoriser une ou plusieurs desdites séries des indications iconique accessible pendant l'usage par le microcontrôleur pour visualiser la série desirèe des indications iconique sur ledit écran, caractérisé en ce que les entrées de l'utilisateur sont en forme de caractères manuels entrés sur l'écran (138) par un style (140), le dispositif comprenant en outre des moyens d'identificatin (210) des caractères pour identifier les entrées de l'utilisateur.

2. Dispositif de télécommande selon la revendication 1, caractérisé en ce que les entrées sont engendrées en touchant les indicatios iconique qui apparaissent sur l'écran.

3. Dispositif de télécommande selon la revendication 1, dans lequel la mémoire et le microcontrôleur forment une cart de commande insérable dans le télécontrôleur pendant l'usage.

4. Dispositif de télécommande selon la revendication 1, dans lequel la mémoire comprend une cart de mémoire insérable dans le télécontrôleur pendant l'usage.

5. Dispositif de télécommande selon l'une quelconque des revendications précédentes, dans lequel la mémoire comprend une EPROM.

6. Dispositif de télécommande selon l'une quelconque des revendications précédentes, dans lequel les moyens de transmission comprendent un trasmetteur IR, dont signals sont décodés, pendant l'usage, par l'équipement pour effectuer l'entrée de contrôle par l'utilisateur.

7. Dispositif de télécommande selon l'une quelconque des revendications précédentes, dans lequel le microcontrôleur sélectionne la série demandé des indications iconique en response à l'entrée de l'utilisateur, en ce que concerne l'équipement à contrôler et est commutable d'une série des indicatios iconique à la série suivante en réponse à une autre entrée de l'utilisateur.

8. Dispositif de télécommande selon l'une quelconque des revendications précédentes pour contrôler un ensemble de télévision.

9. Dispositif de télécommande selon l'une quelconque des revendications précédentes pour contrôler un groupe de magnétoscope et videoreproducteur.

10. Dispositif de télécommande selon l'une quelconque des revendications précédentes pour contrôler certains ou tous les équipements eléctriques domestique.
